# DEMANDE DE BREVET EUROPEEN

(11) **EP 0 886 316 A1**
(43) Date de publication de la demande: **23.12.1998**
(21) Numéro de dépôt: 98410069.3
(22) Date de dépôt: 16.06.1998
(51) Int. Cl.: H01L 27/02

(54) **Protection du caisson logique d'un composant incluant un transistor MOS de puissance intégré**

(30) Priorité: 17.06.1997 FR 9707741
(71) Demandeur: SGS-THOMSON MICROELECTRONICS S.A., 94250 Gentilly (FR)
(72) Inventeur: Claverie, Isabelle, 13850 Greasque (FR)
(74) Mandataire: de Beaumont, Michel

(57) **Abrégé**

L'invention concerne une structure de prise de masse sur un composant comprenant un transistor MOS de puissance vertical et des composants logiques, le substrat (1, 2) d'un premier type de conductivité du composant correspondant au drain du transistor MOS et les composants logiques étant formés dans au moins un caisson (10) du deuxième type de conductivité et du côté de la face supérieure du substrat. Dans le caisson logique, est formée une région du premier type de conductivité (30) sur laquelle est formée une métallisation de façon à réaliser d'une part un contact ohmique, d'autre part un contact redresseur.

## Description

La présente invention concerne les composants associant dans un même substrat des transistors MOS de puissance verticaux de type diffusé (VDMOS) et des circuits logiques, et concerne plus particulièrement l'utilisation de tels composants dans des circuits alimentés par une batterie tels que des circuits automobiles.

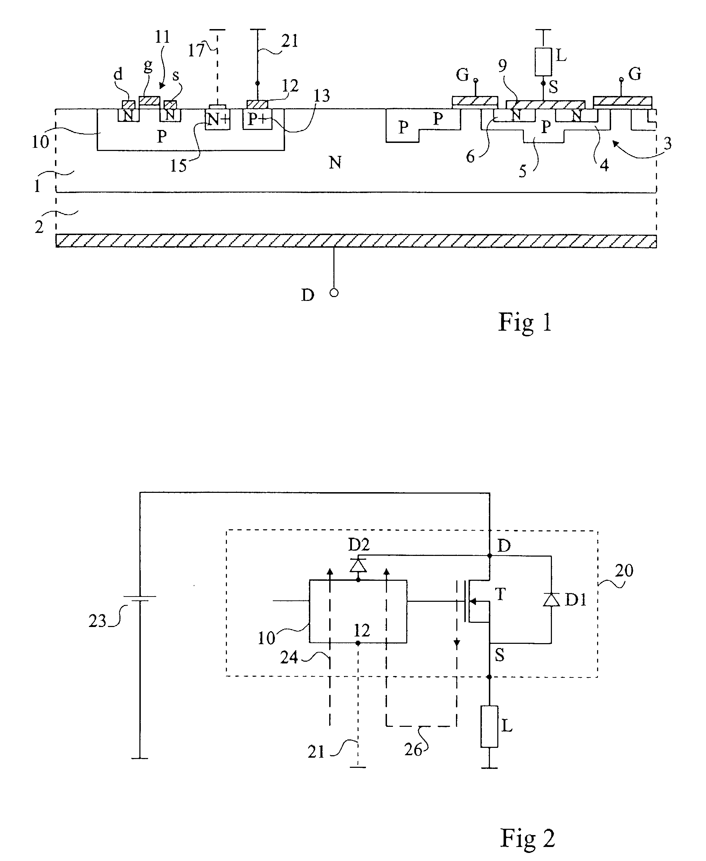

La figure 1 représente très schématiquement une portion d'un tel composant. Celui-ci comprend un substrat de type N généralement constitué d'une couche épitaxiée 1 de type N formée sur un substrat 2 de type N⁺. Dans la partie droite est formé un transistor de puissance et dans la partie gauche un caisson logique.

Le transistor de puissance comporte un ensemble de cellules identiques connectées les unes aux autres, telles que la cellule 3. Chaque cellule comprend un caisson 4 de type P dont la partie centrale 5 est plus fortement dopée. Un anneau 6 de type N est formé dans la partie supérieure du caisson. La partie séparant la périphérie externe de l'anneau 6 de la périphérie externe du caisson 4 est revêtue d'une grille isolée 8. L'anneau 6 de type N ainsi que la partie centrale 5 du caisson sont revêtus d'une métallisation 9. Toutes les grilles 8 sont connectées à une borne de grille G et toutes les métallisations 9 sont reliées à une borne de source S. La face arrière de la structure est revêtue d'une métallisation de drain D. Ainsi, quand un signal de grille est appliqué, un courant est susceptible de s'écouler de la borne D à la borne S depuis les régions N 1 et 2 vers les régions N 6, en passant par un canal formé sous les grilles isolées. Cette structure est généralement utilisée de sorte que le drain est polarisé à un potentiel positif par rapport à la source.

Des éléments de circuits logiques sont formés dans un ou plusieurs caissons 10. On a représenté dans un caisson 10 un transistor MOS élémentaire 11 ayant des bornes de drain, de source et de grille g, d et s. Ceci ne constitue qu'un exemple de composant susceptible d'être formé dans un caisson logique.

Les tensions sur les divers composants formés dans le caisson logique doivent être appliquées par rapport à une référence. La façon la plus simple de prendre cette référence, c'est-à-dire de réaliser une prise de masse, est illustrée en figure 1 et correspond à l'utilisation d'une prise de contact de caisson 12 formé sur une région 13 de même type (P) que le caisson et plus fortement dopée. Le contact 12 dans des modes de réalisation simples pourra être relié directement à la masse. De façon générale, on comprendra que par exemple, des tensions hautes VDD sont appliquées à certains drains des transistors MOS du circuit logique qui ont leur sources connectées au contact 12 et à la masse.

La figure 2 représente un exemple de montage d'un composant du type de celui représenté en figure 1. Le composant est désigné de façon générale par le bloc 20 entouré d'un cadre en pointillés. Une diode inverse D1 est illustrée en parallèle entre le drain et la source du transistor MOS de puissance T et correspond à la jonction entre le substrat 1 de type N et la région 5 de type P. Le caisson 10 est figuré par un bloc et l'on considère qu'il est connecté au drain D du transistor MOS par l'intermédiaire d'une diode D2 correspondant à la jonction entre le substrat 1 et le caisson 10.

Dans un exemple de montage très simple, le contact 12 du caisson est relié à la masse par une connexion 21 ; et la source du transistor de puissance est reliée à la masse par l'intermédiaire d'une charge L dont on souhaite assurer l'alimentation commutée par le transistor de puissance. Une source d'alimentation telle qu'une batterie 23 est connectée entre la masse et la borne de drain D du transistor de puissance T. Ainsi, en fonctionnement normal, les diodes D1 et D2 sont polarisées en inverse. Selon sa commande, le transistor T sera rendu passant ou non et il ne circule aucun courant de la masse (contact 12) vers la face arrière du composant (borne D) en raison de l'existence de la diode D2 polarisée en inverse.

On doit toutefois considérer deux incidents susceptibles de se produire dans des circuits alimentés par batterie, et plus particulièrement des circuits automobiles.

Le premier incident correspond à une inversion de polarisation de la batterie. Les diodes D1 et D2 sont alors polarisées en direct. Le courant dans la diode D1 est limité par la présence de la charge L. Ainsi, le courant s'écoulera essentiellement dans la diode D2, comme cela est indiqué par la flèche 24. Ce courant est susceptible d'être destructif.

Un deuxième incident correspond à une interruption d'alimentation, ou déconnexion de batterie, susceptible de se produire quand, par suite de vibrations ou pour toute autre raison, un fil d'amenée de la batterie se rompt ou fonctionne de façon intermittente. Alors, si la charge L est inductive, elle imposera la continuation du courant qui la traverse selon le trajet désigné par la flèche 26. On notera que ce courant existera nécessairement, la charge L devant être considérée comme une source de courant. Dans le cas du montage simple de la figure 1, le passage de ce courant ne pose pas de problème particulier. Les problèmes résultent de l'utilisation des protections connues contre les inversions de tension de batterie, comme on le verra ci-après.

Une première solution classique pour résoudre le problème de l'inversion de batterie consiste à insérer en série avec le caisson une diode polarisée en sens inverse de la diode D2. L'insertion d'une diode peut par exemple être faite de la façon illustrée en figure 1, en rajoutant une région 15 de type N⁺, en reliant cette région 15 à la masse par une connexion 17 et en supprimant la connexion à la masse 21. Diverses solutions ont été proposées pour optimiser le fonctionnement de cette diode, et pour permettre de disposer d'un caisson référencé à la masse quand le circuit est dans un état de fonctionnement normal. On se référera en particulier au brevet des Etats Unis d'Amérique N° 5099302 (Antoine Pavlin) concernant une diode active. Il demeure toutefois le problème que, en cas de déconnexion de batterie, le courant 26 devra traverser une diode en avalanche et y dissipera une puissance importante, ce qui peut entraîner une destruction du composant à moins de prévoir une diode de grande surface, ce qui augmente indûment le coût du composant.

Une deuxième solution pour résoudre le problème de l'inversion de batterie consiste à placer en série dans la connexion 21 une résistance dont une borne constituera la prise de masse. Mais on se trouve à nouveau devant un dilemme difficilement soluble. En effet, en fonctionnement normal, la résistance doit être aussi faible que possible pour limiter la chute de tension à ses bornes provoquée par la consommation des éléments du circuit logique. Par contre, pour résoudre les problèmes liés au cas de l'inversion de batterie, il est nécessaire que cette résistance soit la plus élevée possible pour limiter le courant circulant dans le caisson.

Ainsi, un objet de la présente invention est de prévoir une structure de prise de masse du caisson logique d'un composant intégrant un transistor de puissance et des éléments logiques qui ne nuise pas au fonctionnement en régime normal, qui empêche la circulation de courant dans le caisson logique en cas d'inversion de batterie, et qui laisse passer le courant résultant d'une déconnexion de batterie.

Pour atteindre ces objets, la présente invention prévoit une structure de prise de masse sur un composant comprenant un transistor MOS de puissance vertical et des composants logiques, le substrat d'un premier type de conductivité du composant correspondant au drain du transistor MOS et les composants logiques étant formés dans au moins un caisson du deuxième type de conductivité et du côté de la face supérieure du substrat. Cette structure comprend, dans le caisson logique, une région du premier type de conductivité sur laquelle est formée une métallisation de façon à réaliser d'une part un contact ohmique, d'autre part un contact redresseur.

Selon un mode de réalisation de la présente invention, le contact redresseur correspond à un contact avec des régions du deuxième type de conductivité.

Selon un mode de réalisation de la présente invention, le contact redresseur correspond à un contact Schottky.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente une structure classique de composant associant un transistor MOS vertical et des circuits logiques ;
la figure 2 représente un exemple de montage du composant de la figure 1 associé à une batterie ;
la figure 3 représente une structure de prise de masse de caisson logique selon la présente invention ;
les figures 4A et 4B représentent des schémas équivalents associés à la structure de prise de masse selon la présente invention ;
la figure 4C représente une caractéristique courant-tension ;
la figure 5 représente une vue schématique et simplifiée d'un exemple de structure de prise de masse selon la présente invention ; et
la figure 6 représente une variante de structure de prise de masse selon la présente invention.

Dans ces diverses figures, de mêmes éléments sont désignés par de mêmes références. Par ailleurs, dans les diverses vues en coupe de composants semiconducteurs, conformément à l'usage, les divers dimensions ne sont pas tracées à l'échelle mais arbitrairement dilatées pour faciliter la lisibilité des figures.

La structure de prise de masse selon la présente invention comprend une région 30 de type N formée dans le caisson logique 10. Dans cette région de type N, sont formées des régions alternées de type N⁺ et P⁺, par exemple en forme de quadrillage, respectivement désignées par les références 31 et 32. L'ensemble des régions 31 et 32 est revêtu d'une métallisation 33, elle-même normalement reliée à la masse du circuit par une connexion correspondant à la connexion 21 de la figure 2.

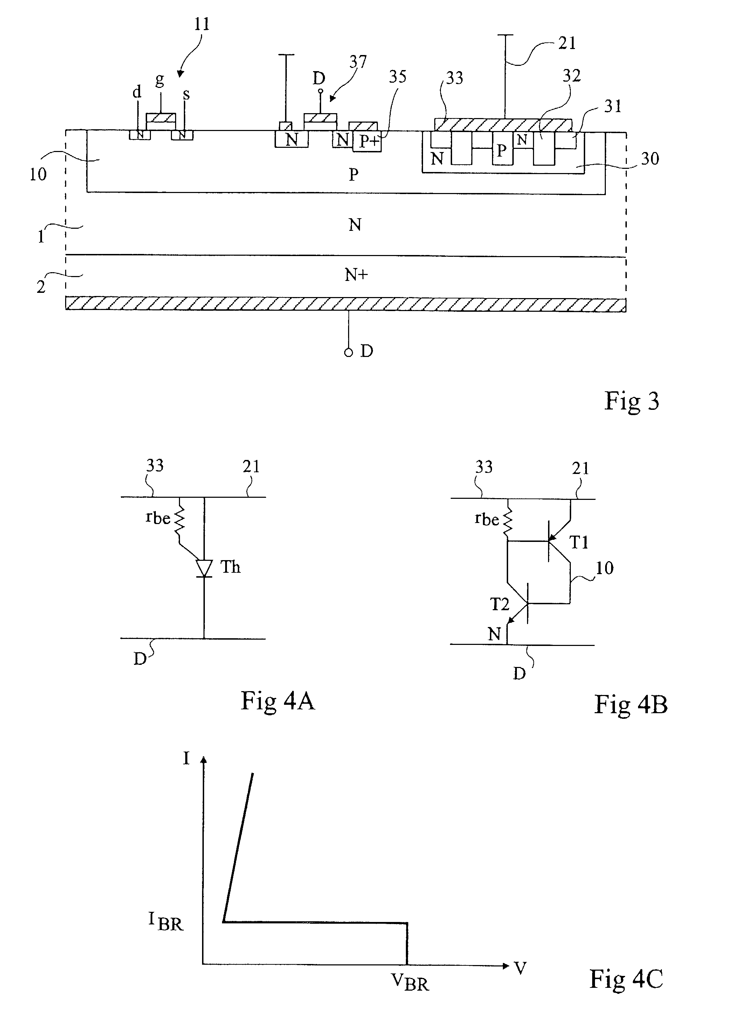

Les figures 4A et 4B représentent deux formes d'un schéma équivalent de la structure de prise de masse, vue entre la connexion 21 et la borne D (face arrière du composant). On peut considérer que cette structure correspond à un thyristor Th dont l'anode correspond à la métallisation 33 et la cathode à la métallisation de face arrière D. L'anode du thyristor correspond aux régions de type P⁺ 32 et il existera une région résistive entre l'anode et la gâchette d'anode de ce transistor, cette résistance étant désignée par la référence r_{be}. La figure 4B représente le même schéma mais dans lequel le thyristor a été représenté de façon classique sous forme de ses transistors équivalents. La région P⁺ 32, le caisson N 30 et la région de caisson 10 de type P forment un transistor PNP T1 dont l'émetteur est connecté à la métallisation 33 et dont la base est connectée par l'intermédiaire de la résistance r_{be} à cette métallisation 33. La région 30, le caisson 10 et le substrat 1 forment un transistor NPN T2 dont l'émetteur est relié à la métallisation de drain D, dont le collecteur est relié à la base du transistor T1 et dont la base est reliée au collecteur du transistor T1. On notera que la région commune de base du transistor T2 et de collecteur du transistor T1 correspond au caisson 10, c'est-à-dire au potentiel de référence VSS des éléments du circuit logique formé dans le caisson 10.

Ainsi, lors du fonctionnement normal du circuit, le thyristor Th est polarisé en inverse et aucun courant ne peut circuler à travers la jonction entre le substrat 1 et le caisson 10.

La caractéristique courant-tension de la structure apparaît en figure 4C dans laquelle on considère une tension V sur la métallisation 33 positive par rapport à la borne D qui se trouve alors à la masse, ce qui se produit en cas d'inversion de batterie. La jonction entre le caisson N 30 et le caisson P 10 est polarisée en inverse et aucun courant ne peut circuler tant que la tension appliquée est inférieure à la tension de claquage V_{BR} de cette jonction. La structure doit être réalisée pour que la tension de claquage V_{BR} soit supérieure à la tension inverse de batterie, de façon à protéger la partie logique du circuit formée dans le caisson 10.

En cas de déconnexion de batterie, la charge inductive L impose le passage d'un courant qui force la jonction entre le caisson N 30 et le caisson P 10 à entrer en avalanche. Lorsque le courant qui circule dans la résistance r_{be} atteint une valeur seuil, notée I_{BR} sur la figure 4C, telle que la valeur de la chute de tension aux bornes de la résistance soit supérieure à 0,6 V, le transistor T1 se met en conduction. Ceci alimente la base du transistor T2 qui s'amorce également. En d'autres termes ceci provoque le retournement du thyristor Th et la chute de tension aux bornes de ce thyristor devient très faible, ce qui permet de dissiper des courants élevés sans risque de destruction en cas de déconnexion de batterie sous charge inductive. Le seuil de retournement I_{BR} doit être optimisé de sorte qu'il soit suffisamment élevé pour ne pas provoquer de retournement intempestif de la caractéristique en cas d'inversion de batterie et suffisamment faible pour que la structure puisse dissiper le courant I_{BR} sous la tension de claquage V_{BR}

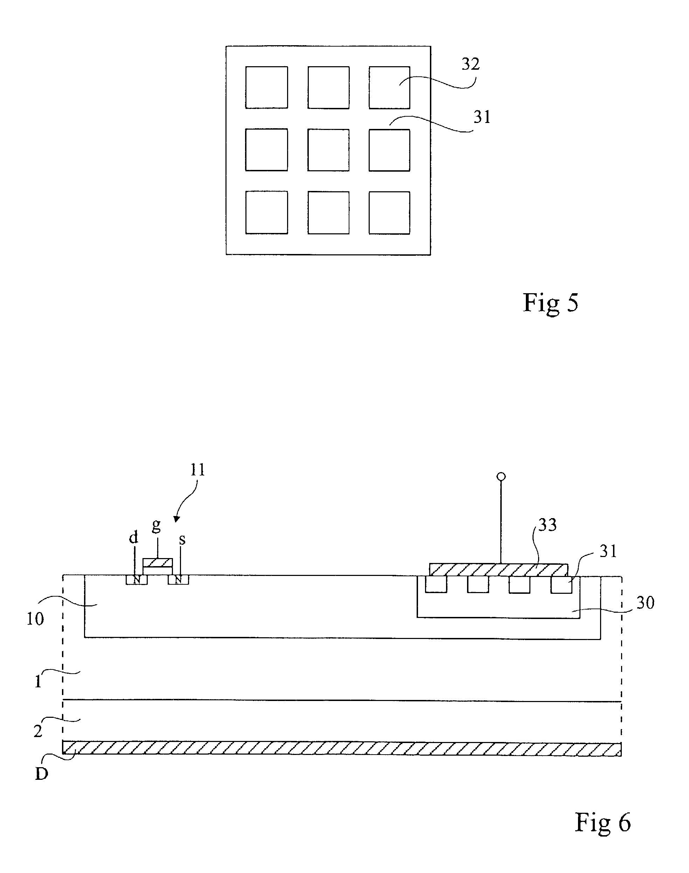

On notera selon un premier avantage de la présente invention que le seuil de déclenchement du circuit de protection selon l'invention est facilement ajustable. En effet, si l'on considère une vue de dessus de cette structure de protection, telle que représentée en figure 5, les régions 32 de type P peuvent être considérées comme un quadrillage séparé par des régions de type N 31. Le rapport de surface entre les régions P et N 32 et 31 détermine la valeur de la résistance r_{be}. Le rapport de surface entre les régions P et N sera par exemple de l'ordre de 15 à 1, le courant de déclenchement étant plus faible quand ce rapport est plus élevé. Dans un exemple de réalisation, chacun des carreaux 32 peut avoir un côté de l'ordre de 8 µm et la distance entre deux carreaux peut être de 2 µm.

Selon un autre avantage de la présente invention, la métallisation 33 n'a pas une surface supérieure à la surface normalement prévue pour établir un plot de contact sur le caisson P 10. Ainsi, il n'y a pas d'augmentation de surface par rapport à la réalisation normale du caisson. On soulignera ici à nouveau que les représentations des diverses figures ne sont pas à l'échelle.

On a décrit ci-dessus les modes de fonctionnement en régimes d'inversion et de déconnexion de batterie. Il faut aussi que le caisson logique soit au potentiel de la masse en régime normal. Pour cela, on pourra par exemple utiliser une structure telle que celle illustrée en figure 3, en s'inspirant de la structure décrite dans le brevet des Etats Unis d'Amérique N° 5099302 susmentionné. Par exemple, il est prévu une région 35 fortement dopée de type P reliée à la masse par l'intermédiaire d'un transistor MOS 37. La grille du transistor 37 est reliée à la borne D, d'où il résulte que le transistor MOS 37 est passant quand la batterie est convenablement connectée (régime normal) et bloqué dans les autres cas (régime d'inversion ou de déconnexion de batterie).

La figure 6 représente une variante du circuit selon la présente invention dans laquelle on retrouve les mêmes éléments que ceux de la figure 3 désignés par les mêmes références. La différence entre ces deux figures est que les régions de type P⁺ 32 ont été supprimées et que le niveau de dopage de la région 30 de type N est choisi pour former une diode Schottky avec la métallisation 33, qui sera par exemple en aluminium. La diode Schottky provoque une injection de porteurs minoritaires limitée, moins efficace que la jonction P⁺-N 32-30, mais suffisante pour créer un effet bipolaire analogue à celui créé par le transistor T1 de la figure 4B. L'intérêt de cette structure est de supprimer un niveau de masquage P⁺.

Bien entendu, la présente invention est susceptible de diverses variantes qui apparaîtront à l'homme de l'art.

## Revendications

1. Structure de prise de masse sur un composant comprenant un transistor MOS de puissance vertical et des composants logiques, le substrat (1, 2) d'un premier type de conductivité du composant correspondant au drain du transistor MOS et les composants logiques étant formés dans au moins un caisson (10) du deuxième type de conductivité et du côté de la face supérieure du substrat, caractérisée en ce qu'elle comprend, dans le caisson logique, une région du premier type de conductivité (30) sur laquelle est formée une métallisation de façon à réaliser d'une part un contact ohmique, d'autre part un contact redresseur.

2. Structure selon la revendication 1, caractérisée en ce que le contact redresseur correspond à un contact avec des régions (32) du deuxième type de conductivité.

3. Structure selon la revendication 1, caractérisée en ce que le contact redresseur correspond à un contact Schottky.
